# FASCICULE DE BREVET EUROPEEN

(11) **EP 3 147 676 B1**
(45) Date de publication et mention de la délivrance du brevet: **02.09.2020**
(21) Numéro de dépôt: 16174890.0
(22) Date de dépôt: 17.06.2016
(51) Int. Cl.: G01R 15/16

(54) **DISPOSITIF DE CONTROLE D'UN CONDUCTEUR ELECTRIQUE ET INSTALLATION ELECTRIQUE COMPORTANT UN TEL DISPOSITIF**
KONTROLLVORRICHTUNG EINES ELEKTRISCHEN LEITERS, UND ELEKTRISCHE ANLAGE, DIE EINE SOLCHE VORRICHTUNG UMFASST
DEVICE FOR MONITORING AN ELECTRICAL CONDUCTOR AND ELECTRICAL INSTALLATION COMPRISING SUCH A DEVICE

(30) Priorité: 10.09.2015 FR 1558399
(43) Date de publication de la demande: 29.03.2017
(73) Titulaire: Schneider Electric Industries SAS, 92500 Rueil-Malmaison (FR)
(72) Inventeur: CAOUS, Philippe, 38050 GRENOBLE (FR); CUMUNEL, Pascal, GRENOBLE (FR); POLLO, Stéphane, 38050 GRENOBLE (FR)
(74) Mandataire: Tripodi, Paul

(56) Documents cités:
- EP-A1- 0 172 634
- EP-A1- 2 857 848
- WO-A1-00/52483
- US-A- 4 700 123

## Description

### DOMAINE TECHNIQUE

L'invention concerne un dispositif de contrôle destiné à être disposé sur un conducteur de ligne électrique et comportant :
- un boîtier de protection,
- un mécanisme d'accrochage dudit boîtier au conducteur de ligne,
- un circuit électronique de contrôle, et
- un capteur de mesure de tension comprenant une électrode de mesure connecté audit circuit électronique.

L'invention concerne aussi une installation électrique comportant au moins un conducteur de ligne, au moins dispositif de contrôle disposé sur ledit conducteur de ligne.

### ETAT DE LA TECHNIQUE

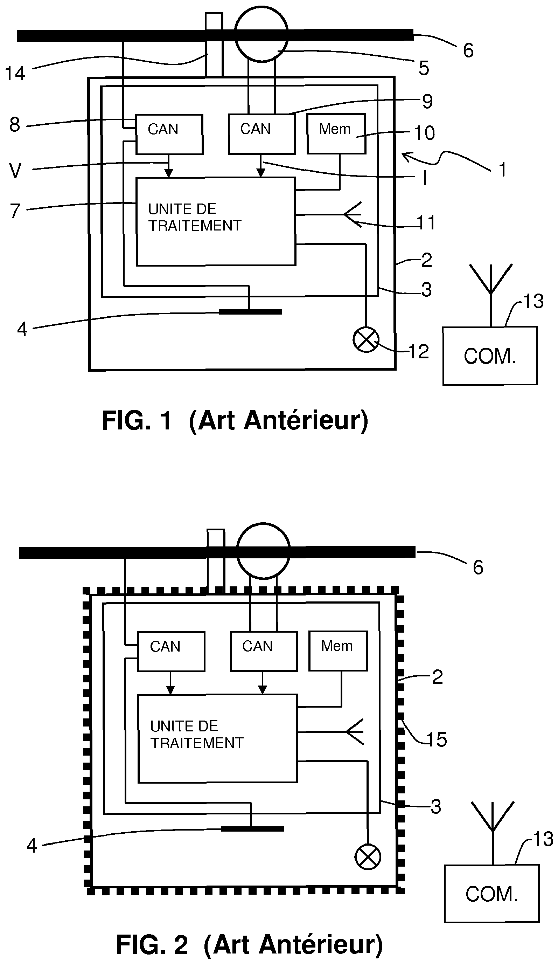

Un schéma d'un dispositif de contrôle de lignes connu, destiné aux lignes aériennes en moyenne tension ou haute tension, est représenté sur la figure 1. Ce dispositif de contrôle 1 comporte un boîtier 2 comprenant un circuit électronique 3 de contrôle et un capteur de mesure de tension comprenant une électrode 4 de mesure connectée audit circuit électronique.

Le circuit électronique 3 comporte également une entrée connectée à un capteur de courant 5. Le capteur de courant comporte généralement un transformateur de courant comportant un circuit magnétique et un enroulement secondaire connecté au circuit électronique 3. Le circuit magnétique est destiné à entourer un conducteur de ligne constituant le conducteur primaire. Sur l'exemple de la figure 1, le circuit électronique comporte une unité de traitement 7 recevant un signal de tension converti par un premier convertisseur analogique-numérique 8 connecté à l'électrode de tension 4 et au conducteur de 6 de ligne. Un signal de courant I est aussi reçu par l'unité 7 et converti par un second convertisseur analogique-numérique 9 connecté au capteur de courant 5. L'unité de traitement 7 est également connectée à une mémoire 10, optionnellement à une antenne 11 de communication, et/ou à un dispositif de visualisation à distance 12. L'unité de traitement analyse les signaux de tension V et/ou de courant I pour détecter et/ou indiquer la direction des défauts électriques, calculer des valeurs de puissance ou d'énergie et/ou transmettre des valeurs de mesure et de traitement à un dispositif de communication à distance 13.

Généralement, le boîtier 2 est fixé sur le conducteur de ligne 6 par un dispositif d'accrochage 14.

Les dispositifs de contrôle sont généralement disposés sur des lignes moyennes ou hautes tension, un par phase sur des lignes triphasées. La détection de courant est mesurée par la détection d'un champ magnétique autour du conducteur 6 alors que la détection et/ou la mesure de tension est faite par la détection d'un champ électrique entre le conducteur et la terre ou le sol avec l'électrode de mesure 4. L'électrode 4 de mesure du champ électrique est soumise à l'influence du conducteur 6 et la terre ainsi que l'influence des autres conducteurs en cas de lignes triphasées. L'influence des lignes voisines est prise en compte lors de la détermination de la valeur de la tension. L'électrode 4 de mesure de tension est généralement une plaque métallique indépendante reliée au circuit électronique ou une partie d'une couche d'un circuit imprimé du circuit électronique 3.

Les boîtiers 2 des dispositifs de contrôle étant utilisés en extérieur, ils sont soumis aux conditions climatiques et notamment aux intempéries. Par conséquent, en cas de forte pluie, notamment lors des saisons de tempête ou de mousson, une pellicule d'eau 15 se forme autour du boîtier. Comme représenté sur la figure 2, cette pellicule d'eau perturbe le champ électrique autour du boîtier et de l'électrode de mesure 4 qui est à l'intérieur du boîtier. La mesure de tension est alors perturbée et dans des cas extrêmes la mesure tension ou la détection de présence / absence tension n'est plus possible.

De plus, lorsque la détection de tension est associée à la mesure de courant, la détection ou la validation de défauts électriques peut être faussée. Le dispositif peut alors présenter des dysfonctionnements dus aux conditions météorologiques ou climatiques sévères.

Des documents EP0172634, WO00/52483 et EP2857848 divulguent des dispositifs similaires de contrôle de lignes électriques haute tension.

### EXPOSE DE L'INVENTION

L'invention a pour but un dispositif de contrôle permettant des mesures de tension électriques moins sensibles aux pluies et plus généralement aux conditions climatiques.

Un dispositif de contrôle selon l'invention est défini dans les revendications.

De préférence, le blindage électrique est déposé par métallisation d'au moins une partie du dispositif de protection. Avantageusement, le blindage électrique est destiné à être relié électriquement au conducteur de ligne à travers le mécanisme d'accrochage.

De préférence, le dispositif de protection est constitué d'au moins une jupe disposée sur le boîtier de protection et ayant un périmètre externe supérieur au périmètre du boîtier et une hauteur supérieure à la hauteur de l'électrode de mesure de tension. Avantageusement, le dispositif de protection a une forme de jupe sensiblement circulaire ou tronconique. Selon une variante, dispositif de protection comporte au moins deux jupes de formes différentes disposées à des endroits différents sur le boîtier de protection.

Dans un mode de réalisation particulier, le dispositif de protection comporte :
- une première jupe ayant un premier périmètre externe et un premier périmètre interne disposé de manière à ce que ledit périmètre interne soit au dessus de la position de l'électrode de mesure de tension et le périmètre externe soit au dessous de la position de ladite électrode, et
- une seconde jupe disposée au dessous de la première jupe et ayant un périmètre externe inférieur à celui de la première jupe.

Avantageusement, le dispositif de protection comporte au moins un épaulement ou un décrochement pour éviter des remontées d'eau à l'intérieur dudit dispositif de protection. De préférence, le dispositif de protection est constitué d'au moins deux parties destinées à être assemblées autour du boîtier de protection.

De préférence, le dispositif de contrôle comporte un capteur de mesure de courant comportant un circuit magnétique et un enroulement secondaire connecté au circuit de traitement, ledit circuit magnétique étant associé au mécanisme d'accrochage du boîtier au conducteur de ligne.

De préférence, le dispositif comporte des moyens de communication sans fil et/ou des moyens de signalisation visuelle connectés à ladite unité de traitement du circuit électronique de contrôle.

Dans une installation électrique selon l'invention comportant au moins un conducteur de ligne et au moins dispositif de contrôle disposé sur ledit conducteur de ligne, ledit dispositif de contrôle est un dispositif de contrôle tel que défini ci-dessus. De préférence, l'installation électrique comporte au moins un dispositif de communication sans fil, ledit dispositif de contrôle étant destiné à communiquer avec ledit dispositif de communication.

### BREVE DESCRIPTION DES DESSINS

D'autres avantages et caractéristiques ressortiront plus clairement de la description qui va suivre, de modes particuliers de réalisation de l'invention, donnés à titre d'exemples non limitatifs, et représentés aux dessins annexés sur lesquels :
- les figures 1 et 2 représentent un schéma d'un dispositif de contrôle de l'art antérieur ;
- les figures 3 et 4 représentent des dessins de dispositifs de contrôle sur lesquels peuvent être disposés des dispositifs de protection selon des modes de réalisation de l'invention ;
- les figures 5 et 6 représentent des schémas de dispositifs de contrôle selon un premier et un second modes de réalisation de l'invention ;
- les figures 7, 8, 9 et 10 montrent des vues d'un dispositif de protection pour un dispositif de contrôle selon l'invention ;
- les figures 11 et 12 représentent des dessins de dispositifs de contrôle selon des variantes de modes de réalisation de l'invention ;
- la figure 13 représente un dessin d'un dispositif de contrôle avec un mécanisme de fixation sur lequel un dispositif de protection selon un mode de réalisation de l'invention peut être installé ;
- les figures 14 et 15 représentent des dessins de dispositifs de contrôle selon un mode de réalisation de l'invention.

### DESCRIPTION DETAILLEE DE MODES DE REALISATION

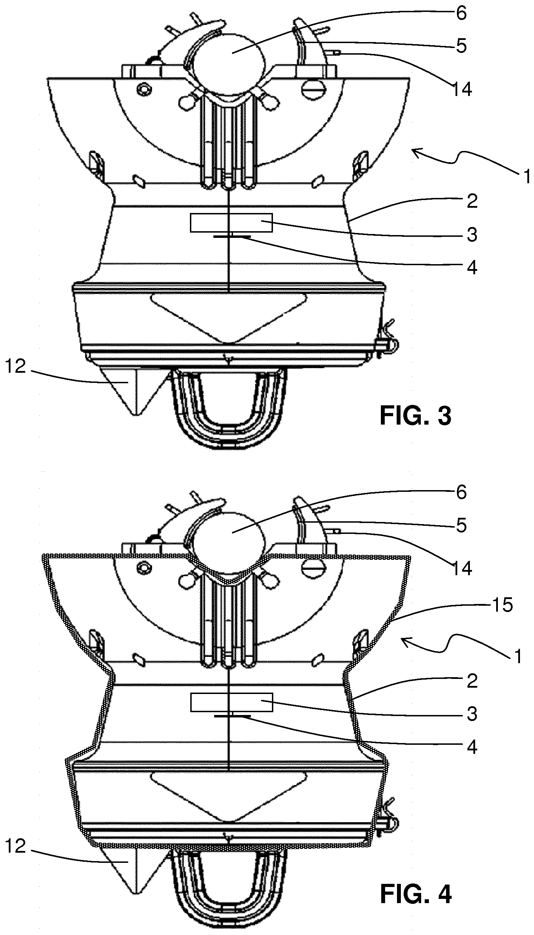

Un exemple de dispositif sur lequel peut être appliquée l'invention est représenté sur les figures 3 et 4. Le dispositif de contrôle 1 est destiné à être fixer à un conducteur 6 de ligne électrique et comporte un boîtier 2 étanche, un mécanisme d'accrochage 5 dudit boîtier au conducteur de ligne 6, un circuit électronique 3 de contrôle, et un capteur de mesure de tension comprenant une électrode 4 de mesure connectée audit circuit électronique 3.

Un tel dispositif est décrit de manière détaillée dans la demande de brevet français numéro FR 15 50427 déposée le 20 janvier 2015. Une autre demande de brevet français FR 14 59145 du 26 septembre 2014 décrit une mesure de tension avec électrode et liaison capacitive. Sur la figure 4, une pellicule d'eau due à de fortes pluies entoure le boîtier 2. Ainsi, lorsque la pluie augmente, l'eau vient progressivement faire écran au champ électrique, d'abord sur la face supérieure, puis sur les faces latérales. Le capteur de champ électrique du dispositif est alors moins sous l'influence des lignes voisines en cas de réseau triphasé. Si la pluie est très forte, la pellicule peut fermer une enveloppe autour du capteur et sur sa face inférieure. Les performances du capteur de champ électrique sont alors dégradées par son environnement, jusqu'à le rendre inutile dans des cas extrêmes.

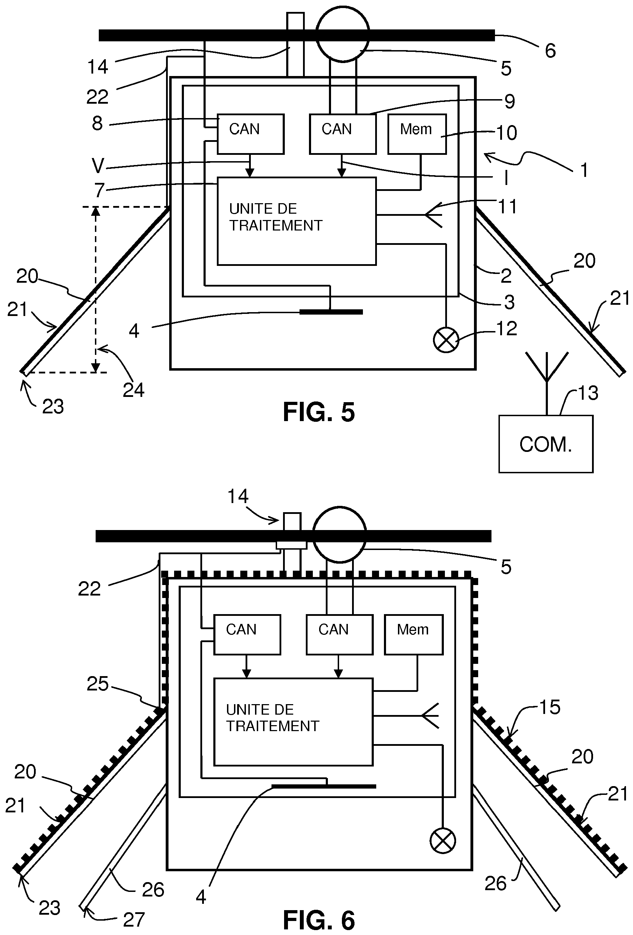

Dans le mode de réalisation de la figure 5, le circuit électronique 3 de contrôle peut comporter également une entrée connectée à un capteur de courant 5. Le capteur de courant comporte généralement un transformateur de courant composé d'un circuit magnétique et d'un enroulement secondaire connecté au circuit électronique 3. Le circuit magnétique est destiné à entourer un conducteur 6 de ligne constituant le conducteur primaire. Le circuit électronique comporte une unité de traitement 7 recevant un signal V de tension converti par un premier convertisseur analogique-numérique 8 connecté à l'électrode de tension 4 et au conducteur de 6 de ligne. L'unité de traitement 7 peut recevoir aussi un signal de courant I converti par un second convertisseur analogique-numérique 9 connecté au capteur de courant 5. Le dispositif de contrôle peut comporter aussi des moyens de communication sans fil avec une antenne 11 et/ou des moyens de signalisation visuelle tel qu'un un dispositif de visualisation à distance 12 et une mémoire 10 connectés à une unité de traitement 7 du circuit électronique 3 de contrôle.

L'unité de traitement analyse les signaux de tension V et/ou de courant I pour détecter des défauts électriques, calculer des valeurs de puissance ou d'énergie et/ou transmettre des valeurs de mesure et de traitement à un dispositif de communication à distance 13. Ce dispositif 13 peut être par exemple un relais radio disposé sur un poteau ou un pylône supportant aussi les lignes électriques aériennes.

Sur la figure 5, un dispositif de contrôle selon un mode de réalisation de l'invention comporte un dispositif 20 de protection entourant l'électrode 4 de mesure de tension et s'étendant à l'extérieur du boîtier 2 pour empêcher l'eau de pluie de recouvrir complètement l'électrode 4 de mesure de tension et/ou le boîtier 2 contenant la dite électrode. Ledit dispositif de protection 20 comporte également un blindage 21 électrique pour stabiliser les variations de champ électrique dues à des conditions extérieures autour de l'électrode 4 de mesure de tension. De préférence, le blindage 21 du dispositif de protection est relié au potentiel électrique du conducteur 6 par l'intermédiaire d'une liaison électrique 22.

Le dispositif de protection peut être adapté à des dispositifs de contrôle de l'art antérieur. Ainsi, même en conservant les éléments mécaniques existants, le capteur de tension devient de nouveau capable de capter le champ électrique en cas d'intempéries ou de très fortes pluies.

Le dispositif de protection peut avoir une forme de jupe métallique entourant la zone où se situe le capteur de champ électrique tel une électrode 4. De cette manière, la jupe du dispositif de protection empêche la fermeture d'une pseudo-cage de Faraday créée par la pellicule d'eau.

Dans ce cas, la jupe a un périmètre externe 23 supérieur au périmètre du boîtier et une hauteur 24 supérieure à la hauteur de l'électrode de mesure de tension. Ladite jupe a de préférence une forme de jupe sensiblement circulaire ou tronconique.

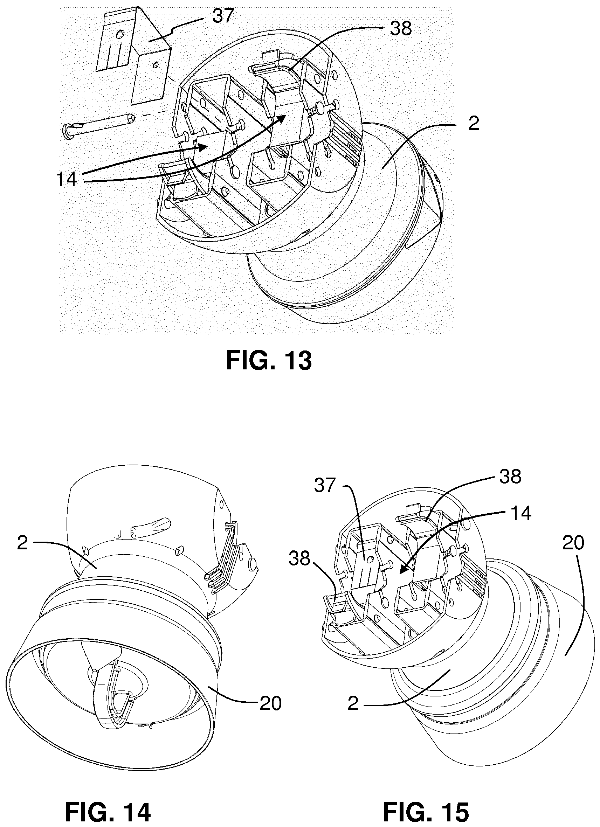

Le blindage électrique est de préférence déposé par métallisation d'au moins une partie du dispositif de protection. Par exemple, la métallisation peut être réalisée par dépôt de peinture. Le blindage permet d'éviter le phénomène d'écran qui apparaît autour du boîtier lorsque la pluie vient créer une pellicule d'eau. Sans blindage du dispositif de protection, les lignes de champ seraient différentes avec ou sans pluie. Ainsi, avec blindage ou métallisation, les lignes de champ restent les mêmes quelle que soit la météo. Le capteur de tension se retrouve alors dans un environnement constant concernant le champ électrique, qu'il pleuve ou non. Sur la figure 15, la couche de pluie 15 sur le dispositif de protection et son blindage métallique 21 ne modifie pas ou très peu les conditions de mesure du champ dans électrique par le capteur comportant l'électrode 4. La mesure est ainsi plus sûre et plus fiable.

Dans un mode particulier de réalisation, le blindage électrique peut être relié électriquement au conducteur de ligne à travers le mécanisme d'accrochage. Sur la figure 6, la liaison 22 relie le blindage 21 au mécanisme d'accrochage 14 pour être connecté électriquement aussi au conducteur de ligne 6. Ces liaisons permettent d'améliorer la mesure du champ électrique et par conséquent de la tension électrique par effet diviseur capacitif. L'autre entrée du capteur de tension est reliée à l'électrode de mesure placée à l'abri des influences de son environnement grâce à la jupe du dispositif de protection.

Le dispositif de protection peut comporter plusieurs jupes de formes différentes disposées à des endroits différents sur le boîtier. Sur la figure 6, le dispositif de protection comporte :
- une première jupe 20 ayant un premier périmètre externe 23 et un premier périmètre interne 25 disposée de manière à ce que le périmètre interne soit au dessus de la position de l'électrode 4 de mesure de tension et le périmètre externe soit au dessous de la position de ladite électrode 4, et
- une seconde jupe 26 disposée au dessous de la première jupe 20 et ayant un périmètre extérieur 27 inférieur à celui de la première jupe 20.

Sur le schéma de la figure 6, seulement la première jupe est métallisée.

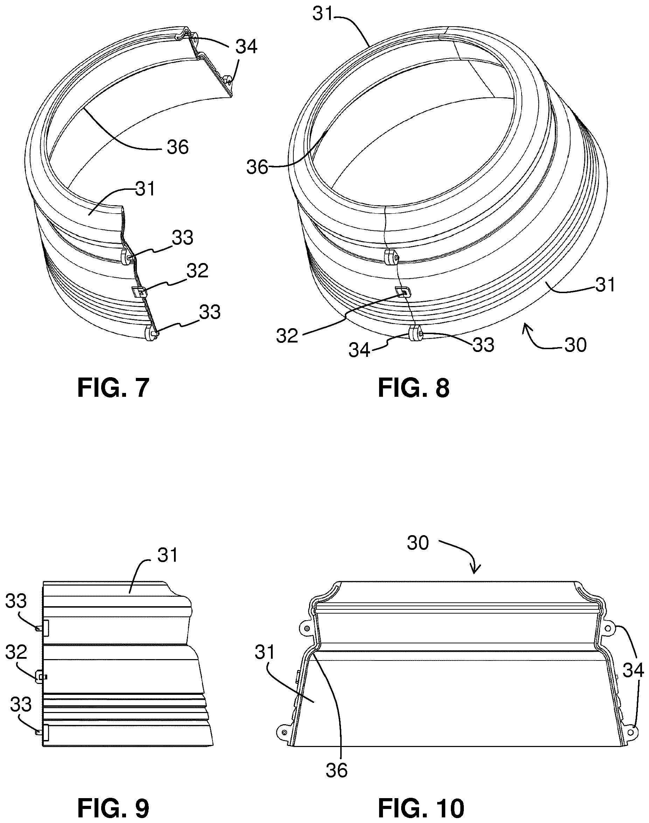

Les figures 7 à 10 illustrent un dispositif de protection 30 constitué en deux parties 31 destinées à être assemblée autour du boîtier de protection. Ainsi, la jupe 30 peut être constituée de deux demi-cônes 31 tronqués identiques présentant des clips 32, des pions 33 et des pattes 34 d'assemblage.

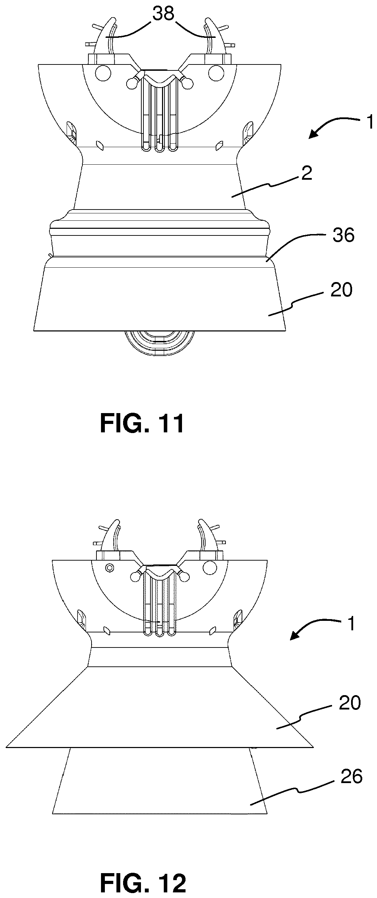

Le dispositif de protection comporte au moins un épaulement ou un décrochement 36 pour éviter des remontées d'eau à l'intérieur dudit dispositif de protection. Sur la figure 10, ledit épaulement est de préférence au moins sur une surface interne 35 faisant face au boîtier 2. Par exemple, plusieurs décrochements de forme tronconiques permettent d'éviter des remontées d'eau pouvant arriver par capillarité sous effet du vent lors de fortes pluies. Un dispositif de contrôle avec une telle jupe est représenté sur la figure 11.

La figure 12 montre une variante avec une première jupe 20 et une seconde jupe 26. Ces autres modes de réalisation peuvent avoir des angles d'évasement, ou des hauteurs ou des périmètres de la jupe différents, ou encore un nombre de jupes différent. Les formes des jupes sont également conditionnées de manière à limiter la prise au vent.

La figure 13 montre un dispositif de contrôle avant la mise en place de son dispositif de protection. Il comporte un élément 37 de connexion électrique telle qu'une plaque métallique permettant de mettre le capteur de tension au potentiel électrique du câble conducteur 6. L'élément 37 est associé au mécanisme 14 comportant des mâchoires de fixation 38.

Optionnellement, le dispositif de contrôle comporte un capteur de mesure de courant 5 comportant un circuit magnétique et un enroulement secondaire connecté au circuit de traitement, ledit circuit magnétique pouvant être associé au mécanisme d'accrochage du boîtier au conducteur de ligne. Ainsi, le mécanisme d'accrochage 14 est associé au capteur de courant et porte la connexion de la prise de tension pour la mesure de tension. Les figures 14 et 15 montrent un dispositif de contrôle monté avec une jupe 20 de protection métallisée et avec l'élément 37 de connexion électrique.

Une Installation électrique tel qu'un réseau de distribution moyenne ou haute tension comporte au moins un conducteur de ligne 6, au moins un dispositif de contrôle 1 disposé sur ledit conducteur 6 de ligne, et optionnellement un dispositif de communication 13 sans fil communiquant avec ledit dispositif de contrôle. Selon un mode réalisation de l'invention, le dispositif de contrôle est un dispositif de contrôle comportant un dispositif de protection tel que décrit ci-dessus destiné à communiquer avec ledit dispositif de communication.

Le dispositif de contrôle décrit ci-dessus est particulièrement destiné aux réseaux moyenne tension ou haute tension cependant il peut tout aussi être utilisé sur des réseau très haute tension ou basse tension.

## Revendications

1. Dispositif de contrôle destiné à être disposé sur un conducteur (6) de ligne électrique et comportant :
- un boîtier (2) de protection,
- un mécanisme (14) d'accrochage dudit boîtier au conducteur (6) de ligne,
- un circuit électronique (3) de contrôle, et
- un capteur (4, 8) de mesure de tension comprenant une électrode (4) de mesure connecté audit circuit électronique (3),
**caractérisé en ce qu'**il comporte un dispositif de protection (20) entourant l'électrode (4) de mesure de tension et s'étendant à l'extérieur du boîtier (2) pour empêcher l'eau de pluie de recouvrir complètement l'électrode de mesure (4) de tension et/ou le boîtier (2) contenant la dite électrode, ledit dispositif de protection (20) comprenant un blindage (21) électrique pour stabiliser autour de l'électrode de mesure de tension les variations de champ électrique dues à des conditions extérieures, ledit blindage (21) électrique étant destiné à être relié électriquement au conducteur (6) de ligne.

2. Dispositif de contrôle selon la revendication 1 **caractérisé en ce que** le blindage (21) électrique est déposé par métallisation d'au moins une partie du dispositif de protection (20).

3. Dispositif de contrôle selon l'une des revendication 1 ou 2 **caractérisé en ce que** le blindage (21) électrique est destiné à être relié électriquement au conducteur (6) de ligne à travers le mécanisme (14) d'accrochage.

4. Dispositif de contrôle selon l'une quelconque des revendications 1 à 3 **caractérisé en ce que** le dispositif (20) de protection est constitué d'au moins une jupe disposée sur le boîtier (2) de protection et ayant un périmètre externe (23) supérieur au périmètre du boîtier (23) et une hauteur (24) supérieure à la hauteur de l'électrode de mesure de tension.

5. Dispositif de contrôle selon l'une quelconque des revendications 1 à 4 **caractérisé en ce que** le dispositif de protection (20) a une forme de jupe sensiblement circulaire ou tronconique.

6. Dispositif de contrôle selon l'une quelconque des revendications 1 à 5 **caractérisé en ce que** le dispositif de protection comporte au moins un épaulement ou un décrochement (36) pour éviter des remontées d'eau à l'intérieur dudit dispositif de protection.

7. Dispositif de contrôle selon l'une quelconque des revendications 1 à 6 **caractérisé en ce que** le dispositif de protection (20) est constitué d'au moins deux parties (31) destinées à être assemblées autour du boîtier (2) de protection.

8. Dispositif de contrôle selon l'une quelconque des revendications 1 à 7 **caractérisé en ce que** le dispositif de protection (20) comporte au moins deux jupes (20, 26) de formes différentes disposées à des endroits différents sur le boîtier (2) de protection.

9. Dispositif de contrôle selon la revendication 8 **caractérisé en ce que** le dispositif de protection comporte :
- une première jupe (20) ayant un premier périmètre externe (23) et un premier périmètre interne (25) disposé de manière à ce que ledit périmètre interne soit au dessus de la position de l'électrode (4) de mesure de tension et le périmètre externe (23) soit au dessous de la position de ladite électrode (4), et
- une seconde jupe (26) disposée au dessous de la première jupe (23) et ayant un périmètre externe (27) inférieur à celui de la première jupe.

10. Dispositif de contrôle selon l'une quelconque des revendications 1 à 9 **caractérisé en ce qu'**il comporte un capteur (5) de mesure de courant comportant un circuit magnétique (38) et un enroulement secondaire connecté au circuit de traitement, ledit circuit magnétique étant associé au mécanisme (14) d'accrochage du boîtier au conducteur de ligne.

11. Dispositif de contrôle selon l'une quelconque des revendications 1 à 10 **caractérisé en ce qu'**il comporte des moyens de communication (11) sans fil et/ou des moyens de signalisation visuelle (12) connectés à ladite unité (7) de traitement du circuit électronique de contrôle.

12. Installation électrique comportant au moins un conducteur (6) de ligne et au moins dispositif de contrôle (1) disposé sur ledit conducteur de ligne,
**caractérisé en ce que** ledit dispositif (1) de contrôle est un dispositif de contrôle selon l'une quelconque des revendications 1 à 11.

13. Installation électrique selon la revendication 12 **caractérisée en ce qu'**elle comporte au moins un dispositif de communication sans fil (13), ledit dispositif de contrôle (1) étant destiné à communiquer avec ledit dispositif de communication (13).

## Patentansprüche

1. Kontrollvorrichtung, die dazu ausgelegt ist, an einem Leiter (6) einer Stromleitung angebracht zu werden, und die Folgendes umfasst:
- ein Schutzgehäuse (2),
- einen Mechanismus (14) zum Aufhängen des Gehäuses am Leitungsleiter (6),
- eine elektronische Kontrollschaltung (3) und
- einen Spannungsmessfühler (4, 8), der eine an die elektronische Schaltung (3) angeschlossene Messelektrode (4) umfasst,
**dadurch gekennzeichnet, dass** sie eine Schutzvorrichtung (20) umfasst, welche die Spannungsmesselektrode (4) umgibt und sich außerhalb des Gehäuses (2) erstreckt, um das Regenwasser daran zu hindern, die Spannungsmesselektrode (4) und/oder das diese Elektrode enthaltende Gehäuse (2) vollständig zu bedecken, wobei die Schutzvorrichtung (20) eine elektrische Abschirmung (21) umfasst, um die durch äußere Bedingungen bedingten Schwankungen des elektrischen Feldes um die Spannungsmesselektrode herum zu stabilisieren, wobei die elektrische Abschirmung (21) dazu ausgelegt ist, mit dem Leitungsleiter (6) elektrisch verbunden zu werden.

2. Kontrollvorrichtung nach Anspruch 1, **dadurch gekennzeichnet, dass** die elektrische Abschirmung (21) durch Metallisierung mindestens eines Teils der Schutzvorrichtung (20) aufgebracht wird.

3. Kontrollvorrichtung nach einem der Ansprüche 1 oder 2, **dadurch gekennzeichnet, dass** die elektrische Abschirmung (21) dazu ausgelegt ist, mit dem Leitungsleiter (6) durch den Aufhängungsmechanismus (14) hindurch elektrisch verbunden zu werden.

4. Kontrollvorrichtung nach einem der Ansprüche 1 bis 3, **dadurch gekennzeichnet, dass** die Schutzvorrichtung (20) aus mindestens einer Schürze besteht, die an dem Schutzgehäuse (2) angeordnet ist und einen äußeren Umfang (23), der größer als der Umfang des Gehäuses (2) ist, und eine Höhe (24), die größer als die Höhe der Spannungsmesselektrode ist, hat.

5. Kontrollvorrichtung nach einem der Ansprüche 1 bis 4 **dadurch gekennzeichnet, dass** die Schutzvorrichtung (20) die Form einer im Wesentlichen runden oder kegelstumpfförmigen Schürze hat.

6. Kontrollvorrichtung nach einem der Ansprüche 1 bis 5, **dadurch gekennzeichnet, dass** die Schutzvorrichtung mindestens einen Absatz oder einen Rücksprung (36) umfasst, um das Aufsteigen von Wasser in das Innere der Schutzvorrichtung zu verhindern.

7. Kontrollvorrichtung nach einem der Ansprüche 1 bis 6, **dadurch gekennzeichnet, dass** die Schutzvorrichtung (20) aus mindestens zwei Teilen (31) besteht, die dazu ausgelegt sind, um das Schutzgehäuse (2) herum montiert zu werden.

8. Kontrollvorrichtung nach einem der Ansprüche 1 bis 7, **dadurch gekennzeichnet, dass** die Schutzvorrichtung (20) mindestens zwei Schürzen (20, 26) unterschiedlicher Formen umfasst, die an verschiedenen Stellen am Schutzgehäuse (2) angeordnet sind.

9. Kontrollvorrichtung nach Anspruch 8 **dadurch gekennzeichnet, dass** die Schutzvorrichtung Folgendes umfasst:
- eine erste Schürze (20) mit einem ersten äußeren Umfang (23) und einem ersten inneren Umfang (25), die so angeordnet ist, dass der innere Umfang über der Position der Spannungsmesselektrode (4) liegt und der äußere Umfang (23) unter der Position der Elektrode (4) liegt, und
- eine zweite Schürze (26), die unter der ersten Schürze (20) angeordnet ist und einen geringeren äußeren Umfang (27) als die erste Schürze hat.

10. Kontrollvorrichtung nach einem der Ansprüche 1 bis 9, **dadurch gekennzeichnet, dass** sie einen Strommessfühler (5) umfasst, der einen Magnetkreis (38) und eine an die Verarbeitungsschaltung angeschlossene Sekundärwicklung umfasst, wobei der Magnetkreis dem Aufhängungsmechanismus (14) des Gehäuses am Leitungsleiter zugeordnet ist.

11. Kontrollvorrichtung nach einem der Ansprüche 1 bis 10, **dadurch gekennzeichnet, dass** sie drahtlose Kommunikationsmittel (11) und/oder optische Signalisierungsmittel (12) umfasst, die an die Verarbeitungseinheit (7) der elektronischen Kontrollschaltung angeschlossen sind.

12. Elektrische Anlage, die mindestens einen Leitungsleiter (6) und mindestens eine an dem Leitungsleiter angeordnete Kontrollvorrichtung (1) umfasst, **dadurch gekennzeichnet, dass** die Kontrollvorrichtung (1) eine Kontrollvorrichtung nach einem der Ansprüche 1 bis 11 ist.

13. Elektrische Anlage nach Anspruch 12, **dadurch gekennzeichnet, dass** sie mindestens eine drahtlose Kommunikationsvorrichtung (13) umfasst, wobei die Kontrollvorrichtung (1) dazu ausgelegt ist, mit der Kommunikationsvorrichtung (13) zu kommunizieren.

## Claims

1. Monitoring device intended to be arranged on an electrical line conductor (6) and comprising:
- a protective housing (2),
- a mechanism (14) for hooking said housing to the line conductor (6),
- an electronic monitoring circuit (3), and
- a voltage measurement sensor (4, 8) comprising a measurement electrode (4) connected to said electronic circuit (3),
**characterized in that** it comprises a protection device (20) surrounding the voltage measurement electrode (4) and extending outside the housing (2) so as to prevent rainwater from completely covering the voltage measurement electrode (4) and/or the housing (2) containing said electrode, said protection device (20) comprising an electrical screen (21) in order to stabilize electrical field variations around the voltage measurement electrode caused by external conditions, said electrical screen (21) being intended to be electrically connected to the line conductor (6).

2. Monitoring device according to Claim 1, **characterized in that** the electrical screen (21) is deposited through metallization of at least part of the protection device (20).

3. Monitoring device according to either of Claims 1 and 2, **characterized in that** the electrical screen (21) is intended to be electrically connected to the line conductor (6) by way of the hooking mechanism (14).

4. Monitoring device according to any one of Claims 1 to 3, **characterized in that** the protection device (20) consists of at least one skirt arranged on the protective housing (2) and having an outer perimeter (23) greater than the perimeter of the housing (2) and a height (24) greater than the height of the voltage measurement electrode.

5. Monitoring device according to any one of Claims 1 to 4, **characterized in that** the protection device (20) is in the shape of a substantially circular or frustoconical skirt.

6. Monitoring device according to any one of Claims 1 to 5, **characterized in that** the protection device comprises at least one shoulder or unhooking mechanism (36) for preventing water from rising into said protection device.

7. Monitoring device according to any one of Claims 1 to 6, **characterized in that** the protection device (20) consists of at least two parts (31) that are intended to be joined together around the protective housing (2).

8. Monitoring device according to any one of Claims 1 to 7, **characterized in that** the protection device (20) comprises at least two differently shaped skirts (20, 26) arranged at different locations on the protective housing (2).

9. Monitoring device according to Claim 8, **characterized in that** the protection device comprises:
- a first skirt (20) having a first outer perimeter (23) and a first inner perimeter (25) arranged such that said first inner perimeter is above the position of the voltage measurement electrode (4) and the first outer perimeter (23) is below the position of said electrode (4), and
- a second skirt (26) arranged below the first skirt (20) and having an outer perimeter (27) smaller than that of the first skirt.

10. Monitoring device according to any one of Claims 1 to 9, **characterized in that** it comprises a current measurement sensor (5) comprising a magnetic circuit (38) and a secondary winding connected to the processing circuit, said magnetic circuit being associated with the mechanism (14) for hooking the housing to the line conductor.

11. Monitoring device according to any one of Claims 1 to 10, **characterized in that** it comprises wireless communication means (11) and or visual signalling means (12) connected to said processing unit (7) of the electronic monitoring circuit.

12. Electrical installation comprising at least one line conductor (6) and at least one monitoring device (1) arranged on said line conductor, **characterized in that** said monitoring device (1) is a monitoring device according to any one of Claims 1 to 11.

13. Electrical installation according to Claim 12, **characterized in that** it comprises at least one wireless communication device (13), said monitoring device (1) being intended to communicate with said communication device (13).
